# EUROPEAN PATENT APPLICATION

(11) **EP 3 590 633 A1**
(43) Date of publication of application: **08.01.2020**
(21) Application number: 18777962.4
(22) Date of filing: 26.03.2018
(51) Int. Cl.: B22F 7/04, B22F 1/00, B22F 1/02, B22F 3/14, B22F 7/08, B22F 9/00, B82Y 30/00, H05K 1/18, B22F 9/24

(54) **BONDING MATERIAL AND BONDED BODY USING SAME**

(30) Priority: 28.03.2017 JP 2017063351
(71) Applicant: Dowa Electronics Materials Co., Ltd., Chiyoda-ku Tokyo 101-0021 (JP)
(72) Inventor: HORI, Tatsuro, Tokyo 101-0021 (JP); ENDOH, Keiichi, Tokyo 101-0021 (JP); FUJIMOTO, Hideyuki, Tokyo 101-0021 (JP); KURITA, Satoru, Tokyo 101-0021 (JP)
(74) Representative: Manitz Finsterwald Patent- und Rechtsanwaltspartnerschaft mbB
(86) International application number: PCT/JP2018/011961
(87) International publication number: WO 2018/181083

(57) **Abstract**

There are provided a bonding material capable of bonding an electronic part to a substrate by means of a silver bonding layer which is difficult to form large cracks even if the cooling/heating cycle is repeated, and a bonded product wherein an electronic part is bonded to a substrate by using the same. In a bonded product wherein a semiconductor chip such as an SiC chip (having a bonded surface plated with silver) serving as an electronic part is bonded to a copper substrate via a silver bonding layer containing a sintered body of silver, the silver bonding layer has a shear strength of not less than 60 MPa and has a crystalline diameter of not larger than 78 nm on (111) plane thereof.

## Description

### Technical Field

The present invention relates generally to a bonding material and a bonded product using the same. More specifically, the invention relates to a bonding material of a silver paste containing fine silver particles, and a bonded product wherein an electronic part is bonded to a substrate by means of a silver containing layer which is formed by using the bonding material.

### Background Art

In a conventional semiconductor device wherein an electronic part such as a semiconductor chip is mounted on a metal substrate such as a copper substrate, the electronic part is fixed to the substrate by means of a solder. In recent years, a conventional solder containing lead is transferred to a lead-free solder in view of loads on human body, environment and so forth.

As a semiconductor chip of such a semiconductor device, it is studied to use an SiC chip having a lower loss than that of widely used Si chips and having excellent characteristics. However, in a semiconductor device wherein an SiC chip is mounted on a substrate, there are some cases where the operating temperature thereof is higher than 200 °C, so that it is required to use a high-temperature solder having a high melting point as a solder for fixing the SiC chip to the substrate. However, it is difficult to cause such a high-temperature solder to be a lead-free solder.

On the other hand, in recent years, it is proposed that a silver paste containing fine silver particles is used as a bonding material to be arranged between articles to be heated for a predetermined period of time while applying a pressure between the articles, to sinter silver in the bonding material to bond the articles to each other with a silver bonding layer (see, e.g., Patent Document 1). Such a silver bonding layer formed from a bonding material of a silver paste has a higher melting point than that of usual solders, so that it is attempted to be used in place of a solder for fixing an electronic part such as a semiconductor chip on a substrate.

### Prior Art Document(s)

### Patent Document(s)

Patent Document 1: Japanese Patent Laid-Open No. 2011-80147 (Paragraph Numbers 0014-0020)

### Summary of the Invention

### Problem to be solved by the Invention

However, in a semiconductor device wherein a semiconductor chip such as an SiC chip is mounted on a substrate, if a bonding material of a silver paste is used for fixing the semiconductor chip to the substrate, when the temperature of a silver bonding layer is a high temperature of higher than 100 °C during the operation of the semiconductor device and when a cooling/heating cycle and/or a power cycle is repeated by the on-off of the semiconductor device, there is some possibility that large cracks may be formed in the silver bonding layer due to the difference between the coefficients of thermal expansion of the semiconductor chip or substrate and silver bonding layer, so that the semiconductor chip may be broken to cause the breakdown of the semiconductor device.

It is therefore an object of the present invention to eliminate the aforementioned conventional problems and to provide a bonding material capable of bonding an electronic part to a substrate by means of a silver bonding layer which is difficult to form large cracks even if a cooling/heating cycle is repeated, and a bonded product wherein an electronic part is bonded to a substrate by using the same.

### Means for solving the Problem

In order to accomplish the aforementioned object, a bonded product according to the present invention, comprises: a substrate; a silver bonding layer containing a sintered body of silver; and an electronic part which is bonded to the substrate via the silver bonding layer, wherein the silver bonding layer has a shear strength of not less than 60 MPa and a crystalline diameter of not larger than 78 nm on (111) plane thereof. In this bonded product, a bonded surface of the electronic part to the silver bonding layer is preferably plated with a noble metal, and more preferably plated with silver. The electronic part is preferably an SiC chip, and the substrate is preferably a copper substrate.

According to the present invention, there is provided a bonding material of a silver paste containing fine silver particles, wherein a silver bonding layer has a shear strength of not less than 60 MPa and has a crystalline diameter of not larger than 78 nm on (111) plane thereof when the silver bonding layer is formed by sintering silver in the bonding material by burning the bonding material at 280 °C for 180 seconds after the bonding material is applied on a copper substrate to raise the temperature thereof to 280 °C in 120 seconds while a load of 10 MPa is applied thereon in the atmosphere. In this bonding material, the fine silver particles have an average primary particle diameter of 1 to 100 nm. The bonding material may further contain silver particles having an average primary particle diameter of 0.2 to 10 *µ*m.

Throughout the specification, the expression "average primary particle diameter" means an average value of primary particle diameters of fine silver particles or silver particles obtained on the basis of a scanning electron microscope (SEM) or a transmission electron microphotograph (TEM image).

### Effects of the Invention

According to the present invention, it is possible to provide a bonding material capable of bonding an electronic part to a substrate by means of a silver bonding layer which is difficult to form large cracks even if a cooling/heating cycle is repeated, and a bonded product wherein an electronic part is bonded to a substrate by using the same.

### Brief Description of the Drawings

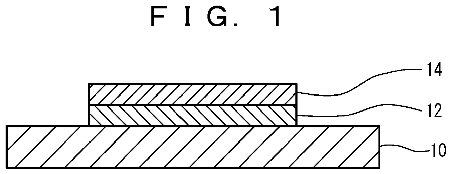

FIG. 1 is a sectional view schematically showing a bonded product, which has an electronic part bonded to a substrate via a silver bonding layer, as an example of the preferred embodiment of a bonded product according to the present invention.

### Mode for Carrying Out the Invention

As shown in FIG. 1, the preferred embodiment of a bonded product according to the present invention, comprises: a substrate 10 (preferably a copper substrate); a silver bonding layer 12 containing a sintered body of silver; and an electronic part 14 (preferably a semiconductor chip such as an SiC chip) which is bonded to the substrate 10 via the silver bonding layer 12, wherein the silver bonding layer has a shear strength of not less than 60 MPa (preferably not less than 70 MPa, more preferably 90 to 150 MPa) and a crystalline diameter of not larger than 78 nm (preferably not larger than 75 nm, more preferably 45 to 74 nm) on (111) plane thereof. Furthermore, the bonded surface of the electronic part 14 is preferably plated with a noble metal such as gold, silver and palladium, in order to enhance the adhesion thereof.

The preferred embodiment of a bonding material according to the present invention is made of a silver paste containing fine silver particles, wherein a silver bonding layer has a shear strength of not less than 60 MPa (preferably not less than 70 MPa, more preferably 90 to 150 MPa) and has a crystalline diameter of not larger than 78 nm (preferably not larger than 75 nm, more preferably 45 to 74 nm) on (111) plane thereof when the silver bonding layer is formed by sintering silver in the bonding material by burning the bonding material at 280 °C for 180 seconds after the bonding material is applied on a copper substrate to raise the temperature thereof to 280 °C in 120 seconds while a load of 10 MPa is applied thereon in the atmosphere.

If the silver bonding layer thus has a shear strength of not less than 60 MPa and a crystalline diameter of not larger than 78 nm on (111) plane thereof, it is possible to bond an electronic part to a substrate by means of a silver bonding layer which is difficult to form large cracks even if the cooling/heating cycle is repeated.

In order to enhance the bond strength (shear strength) when an electronic part or the like is bonded to a substrate by means of a silver bonding layer, the sintering of silver is preferably carried out by raising the burning temperature during bonding and/or by increasing the burning time during bonding. It is considered that, if the sintering of silver is thus sufficiently carried out, atomic diffusion occurs between the silver bonding layer and the substrate to enhance the bond strength. However, it was found that, if the sintering of silver is sufficiently carried out, there is a strong effect on crystal growth to increase the crystalline diameter of the silver bonding layer, so that large cracks are easily formed in the silver bonding layer if a cooling/heating cycle is repeated.

The above-described bonding material preferably contains a solvent and a dispersant in addition to fine silver particles.

The solvent may be a solvent which has such a viscosity that the bonding material is easily printed on a substrate and which can sinter silver in the bonding material to form a silver bonding layer. The solvent may be used alone, or two kinds or more of solvents may be combined to be used. The content of the solvent (s) in the bonding material is preferably 1 to 25 % by weight, and more preferably 5 to 20 % by weight. As the solvent, there may be used any one of polar or non-polar solvents, and there is preferably any one of polar solvents in view of the compatibility with other components in the bonding material and of the load on environment. For example, as the polar solvent, there may be used water, alcohol, polyol, glycol ether, 1-methylpyrrolidinone, pyridine, terpineol, butyl carbitol, butyl carbitol acetate, texanol, phenoxypropanol, diethylene glycol monobutyl ether, diethylene glycol monobutyl ether acetate, *γ*-butyrolactone, ethylene glycol monomethyl ether acetate, ethylene glycol monoethyl ether acetate, methoxybutyl acetate, methoxypropyl acetate, diethylene glycol monoethyl ether acetate, ethyl lactate, 1-octanol or the like. As such a polar solvent, there is preferably used 1-decanol, 1-dodecanol, 1-tetradecanol, 3-methyl-1,3-butanediol-3-hydroxy-3-methylbutyl acetate, 2-ethyl-1,3-hexanediol (octanediol), hexyl diglycol, 2-ethylhexyl glycol, dibutyl glycol, glycerin, dihydroxy terpineol, dihydroxy terpineol acetate, 2-methyl-butane-2,3,4-triol (isoprene triol A (IPTL-A) produced by Nippon Terpene Chemicals, Inc.), 2-methyl-butane-1,3,4-triol (isoprene triol B (IPTL-B) produced by Nippon Terpene Chemicals, Inc.), Terusolve IPG-2Ac (produced by Nippon Terpene Chemicals, Inc.), Terusolve MTPH (produced by Nippon Terpene Chemicals, Inc.), Terusolve DTO-210 (produced by Nippon Terpene Chemicals, Inc.), Terusolve THA-90 (produced by Nippon Terpene Chemicals, Inc.), Terusolve THA-70 (produced by Nippon Terpene Chemicals, Inc.), Terusolve TOE-100 (produced by Nippon Terpene Chemicals, Inc.), dihydroterpinyl oxyethanol (produced by Nippon Terpene Chemicals, Inc.), terpinyl methyl ether (produced by Nippon Terpene Chemicals, Inc.), dihydroterpinyl methyl ether (produced by Nippon Terpene Chemicals, Inc.) or the like, and there is more preferably used at least one of 1-decanol, 1-dodecanol, 2-ethyl-1,3-hexanediol (octanediol), dibutyl glycol, 2-methyl-butane-2,3,4-triol (isoprene triol A (IPTL-A)),
and 2-methyl-butane-1,3,4-triol (isoprene triol B (IPTL-B)) .

If the dispersant is added to the bonding material, it is possible to enhance the dispersability of the fine silver particles in the bonding material to decrease the crystalline diameter of a silver bonding layer which is formed from the bonding material. The dispersant may be used alone, or two kinds or more of dispersants may be combined to be used. The content of the dispersant(s) in the bonding material is preferably 0.01 to 2 % by weight, and more preferably 0.03 to 0.7 % by weight. As the dispersant, there may be used any one of carboxylic acid dispersants such as butoxyethoxy acetic acid, and phosphate ester dispersants.

The average primary particle diameter of the fine silver particles is preferably 1 to 100 nm and more preferably 40 to 100 nm so that it is possible to heat the fine silver particles in the bonding material at a low temperature of 200 to 350 °C to sinter silver to form a silver bonding layer having a high shear strength. The content of the fine silver particles in the bonding material is preferably 60 to 97 % by weight and more preferably 75 to 95 % by weight so that it is possible to form a silver bonding layer having a high shear strength. In order to hold the dispersed condition of the fine silver particles in the bonding material, the fine silver particles are preferably coated with an organic compound. In particular, the organic compound for coating the fine silver particles may be a fatty acid or amine having a carbon number of 3 to 8 so that the organic compound can be removed from the fine silver particles during the sintering of silver to form a silver bonding layer having a high shear strength.

The bonding material may contain silver particles having an average primary particle diameter of 0.2 to 10 *µ*m (preferably 0.2 to 3 *µ*m). Such micron-sized silver particles can be connected to each other by means of fusion-bonded fine silver particles if the fine silver particles in the bonding material is heated at a low temperature of 200 to 350 °C to sinter silver. Thus, the micron-sized silver and the fine silver particles can form a silver bonding layer as a whole. If such micron-sized silver particles are added to the bonding material, it is possible to decrease the viscosity of the bonding material while maintaining a high-content of silver in the bonding material, so that the bonding material can have such a viscosity that it is easily applied on a substrate. When the bonding material contains micron-sized silver particles, the content of silver particles having an average primary particle diameter of 0.2 to 10 *µ*m in the bonding material is preferably 60 % by weight or less, and the total of the content of the fine silver particles and the content of the silver particles having the average primary particle diameter of 0.2 to 10 *µ*m in the bonding material is preferably 61 to 97 % by weight. The micron-sized silver particles are preferably coated with an organic compound (preferably a fatty acid or amine having a carbon number of 6 to 24) in order to enhance the density thereof in the bonding material.

Furthermore, in order to cause the bonding material to form a silver bonding layer having a high shear strength and a small crystalline diameter, a mixture obtained by mixing the fine silver particles, solvent and so forth is preferably cracked by means of a wet jet-mill.

In order to use the above-described bonding material for obtaining a bonded product which has an electronic part bonded to a substrate, the above-described bonding material is applied on the substrate to form a coating film. Then, if necessary, the coating film is heated at 70 to 160 °C for 5 to 60 minutes to volatilize at least part of the solvent in the coating film to form a pre-dried film. Then, an electronic part is arranged on the coating film or pre-dried film, which is burned at 200 to 350 °C for 90 seconds to 30 minutes to sinter silver in the coating film to form a silver bonding layer to bond the electronic part to the substrate with the silver bonding layer. Furthermore, the temperature in heating for forming the pre-dried film can be optionally set in accordance with the kind and amount of the solvent. The burning temperature can be adjusted in the range of from 200 °C to 350 °C. If the burning temperature is high, the sintering of silver proceeds, so that there is a tendency to increase the crystalline diameter of the silver bonding layer although the shear strength of the silver bonding layer increases. The burning time can be adjusted in the range of from 90 seconds to 30 minutes. If the burning time is long, the sintering of silver proceeds, so that there is a tendency to increase the crystalline diameter of the silver bonding layer although the shear strength of the silver bonding layer increases. Moreover, a load of 5 to 40 MPa is preferably applied between the electronic part and the substrate during burning. If the load is high, there is a tendency to increase the shear strength of the silver bonding layer and decrease the crystalline diameter of the silver bonding layer.

### Examples

Examples of a bonding material and a bonded product using the same according to the present invention will be described below in detail.

### [Example 1]

First, 180.0 g of pure water was put in a 300 mL beaker, and 33.6 g of silver nitrate (produced by Toyo Kagaku Inc.) was added thereto to be dissolved to prepare an aqueous silver nitrate solution as a raw material solution.

Then, 3322.0 g of pure water was put in a 5 L beaker, and the temperature thereof was raised to 40 °C while removing dissolved oxygen by blowing nitrogen gas into the pure water for 30 minutes. To this pure water, 44.8 g of sorbic acid (produced by Wako Pure Chemical Industries, Ltd.) was added as an organic compound (for coating fine silver particles), and thereafter, 7.1 g of 28 % ammonia water (produced by Wako Pure Chemical Industries, Ltd.) was added thereto as a stabilizing agent.

While the aqueous solution was stirred after the ammonia water was added, 14.91 g of hydrous hydrazine having a purity of 80 % (produced by Otsuka Chemical Co., Ltd.) was added thereto as a reducing agent after 5 minutes from the addition of the ammonia water (reaction initiation), to prepare an aqueous reducing agent containing solution as a reducing solution. After 9 minutes from the reaction initiation, the raw material solution (aqueous silver nitrate solution), the temperature of which was adjusted to 40 °C, was added to the reducing solution (aqueous reducing agent containing solution) at a stroke to be allowed to react with the reducing solution, and stirred for 80 minutes. Thereafter, the temperature of the solution was raised at a temperature raising rate of 1 °C/min from 40 °C to 60 °C, and the stirring was stopped.

After the aggregates of the fine silver particles coated with sorbic acid were thus formed, a liquid containing the aggregates of the fine silver particles was filtered by a No.5C filter paper, and then, a recovery obtained by filtration was washed with pure water to obtain the aggregates of the fine silver particles. The aggregates of the fine silver particles were dried at 80 °C for 12 hours in a vacuum dryer to obtain a dried powder of the aggregates of the fine silver particles. The dried powder of the aggregates of the fine silver particles thus obtained was cracked to adjust the size of the secondary aggregates. Furthermore, the average primary particle diameter of the fine silver particles was obtained by means of a scanning electron microscope (SEM). As a result, the average primary particle diameter was 85 nm.

Then, there were mixed 89.0 g of the dried powder of the aggregates of the fine silver particles (silver particles 1) (coated with sorbic acid), the size of the secondary aggregates of which was thus adjusted, 9.25 g of octanediol (ODO) (2-ethyl-1,3-hexanediol produced by HK Neochem Co., Ltd.) serving as a first solvent, 1.5 g of 2-methyl-butane-2,3,4-triol (isoprene triol A (IPTL-A)) (produced by Nippon Terpene Chemicals, Inc.) serving as a second solvent, and 0.25 g of 2-butoxyethoxy acetic acid (BEA) (produced by Tokyo Chemical Industry Co., Ltd.) serving as a dispersant. The mixture thus obtained was kneaded at a revolution speed of 1400 rpm and a rotation speed of 700 rpm for 30 seconds by means of a kneading/degassing machine (V-mini 300 produced by EME Co., Ltd.). The mixture thus kneaded was diluted with a mixed solvent (SOLMIX AP-7 produced by Japan Alcohol Treading Co., Ltd.) to be stirred. Then, the mixture was cracked by means of a wet jet mill (RM-L1000EP produced by RIX Corporation), and then, vacuum-degassed by means of a vacuum degassing mixer to evaporate all of the mixed solvent (SOLMIX AP-7) to obtain a bonding material 1 of a silver paste containing 89.0 % by weight of silver particles 1, 9.25 % by weight of the first solvent (ODO), 1.5 % by weight of the second solvent (IPTL-A) and 0.25 % by weight of the dispersant (BEA).

The viscosity of this bonding material 1 was measured at 25 °C by means of a rheometer (viscoelasticity measuring apparatus) (HAAKE Rheostress 600 produced by Thermo Scientific, Inc., used cone: C35/2°). As a result, the viscosity measured at 25 °C and 5 rpm (15.7 [1/s]) was 36 (Pa ▪ s), and the ratio (Ti value) of the viscosity measured at 25 °C and 1 rpm (3.1 [1/s]) to the viscosity at 25 °C and 5 rpm (viscosity at 1 rpm / viscosity at 5 rpm) was 3.1. Furthermore, the content of Ag in the bonding material 1 was obtained by the heating loss method. As a result, the content of Ag was 88.4 % by weight.

The particle size of fine silver particles contained in the bonding material 1 (silver paste) was evaluated by a grind gage (50 *µ*m stainless steel produced by BYK Limited) as follows. First, the grind gage was cleaned with an alcohol solvent (SOLMIX), and sufficiently dried. Then, about 5 to 10 g of the silver paste was put on the side of a deeper groove of the grind gage (on the side of 50 *µ*m), and a scraper was picked up by the thumb and another finger of both hands to be arranged so that the long sides of the scraper were parallel to the width directions of the grind gage while causing the blade edge of the scraper to contact the deep tip portion of the groove of the grind gage. Then, while the scraper was held so as to be perpendicular to the surface of the grind gage, the grind gage was drawn at a uniform velocity to a portion having a depth of zero in one or two seconds in a direction perpendicular to the long sides of the groove. Within 3 seconds after the drawing of the grind gage was completed, light was emitted so as to cause the pattern of the silver paste to be easily visible, and a portion, at which a remarkable line started to appear in the silver paste, was observed from a direction which was perpendicular to the long sides of the groove and which had an angle of 20 to 30° with respect to the surface of the grind gage. Thus, there were obtained the particle size of a line (the first scratch, maximum particle diameter Dₘₐₓ) being the first to appear along the groove, the particle size of a line (the fourth scratch) being the fourth to appear along the groove, and the average particle diameter D₅₀ as the particle size of uniformly appearing 10 or more of lines. Furthermore, there were ignored lines sparsely appearing before the remarkable line started to appear. Since there was one grind gage on each of right and left sides thereof, the average value of the values indicated by the two lines was obtained as the measured result. As a result, the first scratch was not larger than 1 *µ*m, the fourth scratch was not larger than 1 *µ*m, and the average particle diameter D₅₀ was not larger than 1 *µ*m.

Then, a metal mask having a thickness of 120 *µ* m was arranged on a substrate of copper (C1020) having a size of 20 mm x 20 mm x 2 mm, and the above-described bonding material 1 was applied on the copper substrate so as to have a size of 10 mm x 10 mm and a thickness (printing thickness) of 105 *µ*m with a metal squeegee by means of a screen printing machine (SP18P-L produced by Panasonic Factory Solutions Sales & Engineering Japan Co., Ltd.). Thereafter, the copper substrate having the bonding material 1 applied thereon was put on a metal tray to be arranged in an oven (produced by Yamato Scientific Co., Ltd.) to be heated at 118 °C for 14 minutes in the atmosphere to be pre-dried to remove solvents in the bonding material 1 to form a pre-dried film. After the copper substrate having the pre-dried film formed thereon was cooled to 25 °C, an SiC chip (having a size of 5 mm x 5 mm x 0.3 mm and having a bonded surface plated with silver) was arranged on the pre-dried film. Then, the substrate was arranged on a heat press machine (produced by DOWA ELECTRONICS MATERIALS CO., LTD.) to raise the temperature thereof to 280 °C in 120 seconds while applying a load of 10 MPa thereto in the atmosphere. After the temperature thereof reached to 280 °C, the substrate was held for 180 seconds while applying the load of 10 MPa thereto in the atmosphere, to burn the pre-dried film to sinter silver in the bonding material 1 to form a silver bonding layer to bond the SiC chip (having the bonded surface plated with silver) to the copper substrate with the silver bonding layer to obtain a bonded product 1.

With respect to the bonded product 1 thus obtained, the presence of voids in the silver bonding layer was observed by means of an ultrasonic microscope (C-SAM produced by SONOSCAN, INC.). As a result, no voids were observed. The thickness of the silver bonding layer was 46 *µ*m assuming that a thickness obtained by subtracting the thicknesses of the SiC chip and copper substrate from the thickness of the bonded product 1 was the thickness of the silver bonding layer. The bonded product 1 was put in a hot-cold shock machine (TSA-71H-W produced by ESPEC Corporation) to carry out a hot-cold shock test for carrying out 100 cycles, in each of which the bonded product 1 was temperature-raised to 200 °C in 6 minutes after being cooled from 200 °C to -40 °C in 9 minutes in the atmosphere. With respect to the bonded product 1 after the hot-cold shock test, the presence of voids in the silver bonding layer was observed by means of an ultrasonic microscope (C-SAM produced by SONOSCAN, INC.). As a result, voids were observed at four corners on the surface of the silver bonding layer of the bonded product 1. Four straight lines were drawn from the four corners on the surface of the silver bonding layer of the bonded product 1 to the central portion of the surface. Assuming that the length of the line segment of each of the straight lines was La, that the length of the presence of the voids on each of the straight lines was Lc and that the percentage the maximum Lc of the four lengths Lc to La was a crack progress ratio, the crack progress ratio (%) (= Lc x 100/La) was 17 %. Thus, the crack progress ratio of the silver bonding layer of the bonding material 1 was lower than 30 %, so that the bonding of the silver bonding layer of the bonded product 1 was good.

Then, a metal mask having a thickness of 120 *µ* m was arranged on a substrate of copper (C1020) having a size of 10 mm x 10 mm x 1 mm, and the above-described bonding material 1 was applied on the copper substrate so as to have a size of 7 mm x 7 mm and a thickness (printing thickness) of 105 *µ*m with a metal squeegee by means of a screen printing machine (SP18P-L produced by Panasonic Factory Solutions Sales & Engineering Japan Co., Ltd.). Thereafter, the copper substrate having the bonding material 1 applied thereon was put on a metal tray to be arranged in an oven (produced by Yamato Scientific Co., Ltd.) to be heated at 118 °C for 14 minutes in the atmosphere to be pre-dried to remove solvents in the bonding material 1 to form a pre-dried film. After the copper substrate having the pre-dried film formed thereon was cooled to 25 °C, a copper block (having a size of 3 mm x 3 mm x 2 mm) was arranged on the pre-dried film. Then, the substrate was arranged on a heat press machine (produced by DOWA ELECTRONICS MATERIALS CO., LTD.) to raise the temperature thereof to 280 °C in 120 seconds while applying a load of 10 MPa thereto in the atmosphere. After the temperature thereof reached to 280 °C, the substrate was held for 180 seconds while applying the load of 10 MPa thereto in the atmosphere, to burn the pre-dried film to sinter silver in the bonding material 1 to form a silver bonding layer to bond the copper block to the copper substrate with the silver bonding layer to obtain a bonded product 2.

The bond strength of the bonded product 2 was measured in accordance with "Lead-free Solder Test Procedure-V: Test Procedure for Tension and Shear of Solder Joint" in JIS Z3918-5 (2003). Specifically, the copper substrate of the bonded product 2 was fixed, and the copper block bonded to the copper substrate was pushed in horizontal directions to measure a force (N), at which any one of the interface between the copper block and the silver bonding layer, the interior of the silver bonding layer, and the interface of the silver bonding layer and the copper substrate was first broken, by means of a bond strength tester (Full-Universal Type Bond Tester Series 4000 produced by DAGE Corporation) . In this test, it was measured at a shear height of 400 *µ*m, at a shear velocity of 5 mm/min. and at room temperature. Furthermore, in the shear test procedure, the force (N) at the time of breaking was directly measured, and the bond strength was a value depending on the bonded area, so that a value obtained by dividing the force (N) at the time of breaking by the bonded area (3 mm x 3 mm = 9 mm²) was calculated as the bond strength (average shear strength). As a result, the shear strength of the bonded product 2 was 113 MPa, so that the bond strength was high.

Then, a metal mask having a thickness of 120 *µ* m was arranged on a substrate of copper (C1020) having a size of 20 mm x 20 mm x 2 mm, and the above-described bonding material 1 was applied on the copper substrate so as to have a size of 10 mm x 10 mm and a thickness (printing thickness) of 105 *µ*m with a metal squeegee by means of a screen printing machine (SP18P-L produced by Panasonic Factory Solutions Sales & Engineering Japan Co., Ltd.). Thereafter, the copper substrate having the bonding material 1 applied thereon was put on a metal tray to be arranged in an oven (produced by Yamato Scientific Co., Ltd.) to be heated at 118 °C for 14 minutes in the atmosphere to be pre-dried to remove solvents in the bonding material 1 to form a pre-dried film. After the copper substrate having the pre-dried film formed thereon was cooled to 25 °C, an SiC chip (having a size of 5 mm x 5 mm x 0.3 mm) was arranged on the pre-dried film. Then, the substrate was arranged on a heat press machine (produced by DOWA ELECTRONICS MATERIALS CO., LTD.) to raise the temperature thereof to 280 °C in 120 seconds while applying a load of 10 MPa thereto in the atmosphere. After the temperature thereof reached to 280 °C, the substrate was held for 180 seconds while applying the load of 10 MPa thereto in the atmosphere, to burn the pre-dried film to sinter silver in the bonding material 1 to form a silver bonding layer. Furthermore, the SiC chip (the bonded surface of which was not plated with silver) was not bonded to the silver bonding layer.

With respect to the silver bonding layer thus formed, an X-ray diffraction analyzer (RINT-2100 produced by RIGAKU Corporation) was used for measuring X-ray diffraction (XRD) in 40 to 50° /2 *θ* using a Co tube (40 kV / 30 mA) as an X-ray source. From an X-ray diffraction pattern obtained by the measurement of X-ray diffraction, the crystalline diameter (Dx) of the silver bonding layer was obtained by the Scherrer equation (Dhkl = K *λ* / *β* cos *θ*). In this equation, Dhkl denotes a crystallite diameter (the size of a crystallite in a direction perpendicular to hkl) (nm), and *λ* denotes the wavelength (nm) of measuring X-rays (0.178892 nm when a Co target is used), *β* denoting the broadening (rad) (expressed by a half-power band width) of diffracted rays based on the size of the crystallite, *θ* denoting a Bragg angle (rad) of the angle of diffraction (which is an angle when the angle of incidence is equal to the angle of reflection and which uses the angle at a peak top) and K denoting the Scherrer constant (which varies in accordance with the definition of D and *β*, and K = 0.94). Furthermore, peak data on (111) plane were used for carrying out calculation. As a result, the crystallite diameter (Dₓ) of the silver bonding layer was 69 nm on (111) plane.

### [Example 2]

First, 180.0 g of pure water was put in a 300 mL beaker, and 33.6 g of silver nitrate (produced by Toyo Kagaku Inc.) was added thereto to be dissolved to prepare an aqueous silver nitrate solution as a raw material solution.

Then, 3322.0 g of pure water was put in a 5 L beaker, and the temperature thereof was raised to 60 °C while removing dissolved oxygen by blowing nitrogen gas into the pure water for 30 minutes. To this pure water, 44.8 g of sorbic acid (produced by Wako Pure Chemical Industries, Ltd.) was added as an organic compound (for coating fine silver particles), and thereafter, 7.1 g of 28 % ammonia water (produced by Wako Pure Chemical Industries, Ltd.) was added thereto as a stabilizing agent.

While the aqueous solution was stirred after the ammonia water was added, 14.91 g of hydrous hydrazine having a purity of 80 % (produced by Otsuka Chemical Co., Ltd.) was added thereto as a reducing agent after 5 minutes from the addition of the ammonia water (reaction initiation), to prepare an aqueous reducing agent containing solution as a reducing solution. After 9 minutes from the reaction initiation, the raw material solution (aqueous silver nitrate solution), the temperature of which was adjusted to 60 °C, was added to the reducing solution (aqueous reducing agent containing solution) at a stroke to be allowed to react with the reducing solution, and the stirring was stopped when 25 minutes were passed after the reaction initiation.

After the aggregates of the fine silver particles coated with sorbic acid were thus formed, a liquid containing the aggregates of the fine silver particles was filtered by a No.5C filter paper, and then, a recovery obtained by filtration was washed with pure water to obtain the aggregates of the fine silver particles. The aggregates of the fine silver particles were dried at 80 °C for 12 hours in a vacuum dryer to obtain a dried powder of the aggregates of the fine silver particles. The dried powder of the aggregates of the fine silver particles thus obtained was cracked to adjust the size of the secondary aggregates. Furthermore, the average primary particle diameter of the fine silver particles was obtained by means of a scanning electron microscope (SEM). As a result, the average primary particle diameter was 60 nm.

Then, there were mixed 45.0 g of the dried powder of the aggregates of the fine silver particles (silver particles 2) (coated with sorbic acid), the size of the secondary aggregates of which was thus adjusted, 45.0 g of silver powders having an average primary particle diameter of 300 nm (AG-2-1C produced by DOWA ELECTRONICS MATERIALS CO., LTD.) (silver particles 3), 9.25 g of octanediol (ODO) (2-ethyl-1,3-hexanediol produced by HK Neochem Co., Ltd.) serving as a first solvent, 0.5 g of 2-methyl-butane-2,3,4-triol (isoprene triol A (IPTL-A)) (produced by Nippon Terpene Chemicals, Inc.) serving as a second solvent, and 0.25 g of 2-butoxyethoxy acetic acid (BEA) (produced by Tokyo Chemical Industry Co., Ltd.) serving as a dispersant. The mixture thus obtained was kneaded at a revolution speed of 1400 rpm and a rotation speed of 700 rpm for 30 seconds by means of a kneading/degassing machine (V-mini 300 produced by EME Co., Ltd.). The mixture thus kneaded was diluted with a mixed solvent (SOLMIX AP-7 produced by Japan Alcohol Treading Co., Ltd.) to be stirred. Then, the mixture was cracked by means of a wet jet mill (RM-L1000EP produced by RIX Corporation), and then, vacuum-degassed by means of a vacuum degassing mixer to evaporate all of the mixed solvent (SOLMIX AP-7) to obtain a bonding material 2 of a silver paste containing 45.0 % by weight of silver particles 2, 45.0 % by weight of silver particles 3, 9.25 % by weight of the first solvent (ODO), 0.5 % by weight of the second solvent (IPTL-A) and 0.25 % by weight of the dispersant (BEA).

With respect to this bonding material 2, the viscosity, Ti value, content of Ag and particle size thereof were obtained by the same methods as those in Example 1. As a result, the viscosity measured at 25 °C and 5 rpm was 6.5 (Pa ▪ s), the Ti value was 2.5, and the content of Ag was 89.2 % by weight. The first scratch was not larger than 1 *µ*m, the fourth scratch was not larger than 1 *µ*m, and the average particle diameter D₅₀ was not larger than 1 *µ*m.

The bonding material 2 was used for producing a bonded product 1 (wherein an SiC chip having a bonded surface plated with silver was bonded to a copper substrate) by the same method as that in Example 1. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 46 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 26 % which was lower than 30 %, so that the bonding of the silver bonding layer of the bonded product 1 was good.

The bonding material 2 was used for producing a bonded product 2 (wherein a copper block was bonded to a copper substrate) by the same method as that in Example 1. Then, the shear strength was obtained by the same method as that in Example 1. As a result, the shear strength was 78 MPa, so that the bond strength was high. The bonding material 2 was used for attempting to bond an SiC chip (the bonded surface of which was not plated with silver) to a copper substrate via the silver bonding layer by the same method as that in Example 1. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 71 nm.

### [Example 3]

A bonding material 3 of a silver paste containing 46.5 % by weight of silver particles 2, 46.5 % by weight of silver particles 3, 6.25 % by weight of the first solvent (ODO), 0.5 % by weight of the second solvent (IPTL-A) and 0.25 % by weight of the dispersant (BEA) was obtained by the same method as that in Example 2, expect that the amounts of the same fine silver particles (having an average primary particle diameter of 60 nm) (silver particles 2) as those in Example 2, the silver particles (having an average primary particle diameter of 300 nm) (silver particles 3) and the first solvent (ODO) were 46.5 g, 46.5 g and 6.25 g, respectively.

With respect to this bonding material 3, the viscosity, Ti value, content of Ag and particle size thereof were obtained by the same methods as those in Example 1. As a result, the viscosity measured at 25 °C and 5 rpm was 40 (Pa ▪ s), the Ti value was 5.4, and the content of Ag was 92.1 % by weight. The first scratch was not larger than 1 *µ*m, the fourth scratch was not larger than 1 *µ*m, and the average particle diameter D₅₀ was not larger than 1 *µ*m.

The bonding material 3 was used for producing a bonded product 1 (wherein an SiC chip having a bonded surface plated with silver was bonded to a copper substrate) by the same method as that in Example 1. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 60 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 17 % which was lower than 30 %, so that the bonding of the silver bonding layer of the bonded product 1 was good.

The bonding material 3 was used for producing a bonded product 2 (wherein a copper block was bonded to a copper substrate) by the same method as that in Example 1. Then, the shear strength was obtained by the same method as that in Example 1. As a result, the shear strength was 93 MPa, so that the bond strength was high. The bonding material 3 was used for attempting to bond an SiC chip (the bonded surface of which was not plated with silver) to a copper substrate via the silver bonding layer by the same method as that in Example 1. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 73 nm.

### [Comparative Example 1]

There were mixed 82.0 g of the same fine silver particles (silver particles 1) (having an average primary particle diameter of 85 nm) as those in Example 1, 11.99 g of octanediol (ODO) (2-ethyl-1,3-hexanediol produced by HK Neochem Co., Ltd.) serving as a first solvent, 6.0 g of 2-methyl-butane-2,3,4-triol (isoprene triol A (IPTL-A)) (produced by Nippon Terpene Chemicals, Inc.) serving as a second solvent, and 0.01 g of diglycolic acid (DGA) (produced by Midori Kagaku Co., Ltd.) serving as a sintering aid. The mixture thus obtained was kneaded at a revolution speed of 1400 rpm and a rotation speed of 700 rpm for 30 seconds by means of a kneading/degassing machine (V-mini 300 produced by EME Co., Ltd.). The mixture thus kneaded was dispersed by a three-roll mill (EXAKT, Inc.). Thereafter, 0.82 g of octanediol (ODO) serving as a diluent was added thereto to obtain a bonding material 4 of a silver paste containing 81.33 % by weight of silver particles 1, 12.71 % by weight of the first solvent (ODO), 5.95 % by weight of the second solvent (IPTL-A) and 0.01 % by weight of the sintering aid (DGA).

With respect to this bonding material 4, the viscosity, Ti value, content of Ag and particle size thereof were obtained by the same methods as those in Example 1. As a result, the viscosity measured at 25 °C and 5 rpm was 25 (Pa ▪ s), the Ti value was 3.5, and the content of Ag was 80.2 % by weight. The first scratch was not larger than 16 *µ*m, the fourth scratch was not larger than 10 *µ*m, and the average particle diameter D₅₀ was not larger than 4 *µ*m.

The bonding material 4 was used for producing a bonded product 1 (wherein an SiC chip having a bonded surface plated with silver was bonded to a copper substrate) by the same method as that in Example 1, except that the load was 5 MPa during burning. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 41 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 100 % which was higher than 30 %, so that the bonding of the silver bonding layer of the bonded product 1 was not good.

The bonding material 4 was used for producing a bonded product 2 (wherein a copper block was bonded to a copper substrate) by the same method as that in Example 1, except that the load was 5 MPa during burning. Then, the shear strength was obtained by the same method as that in Example 1. As a result, the shear strength was 38 MPa, so that the bond strength was low. The bonding material 4 was used for attempting to bond an SiC chip (the bonded surface of which was not plated with silver) to a copper substrate via the silver bonding layer by the same method as that in Example 1, except that the load was 5 MPa during burning. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 98 nm.

### [Comparative Example 2]

The same bonding material 4 as that in Comparative Example 1 was used for producing a bonded product 1 (wherein an SiC chip having a bonded surface plated with silver was bonded to a copper substrate) by the same method as that in Example 1. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 37 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 79 % which was higher than 30 %, so that the bonding of the silver bonding layer of the bonded product 1 was not good.

The bonding material 4 was used for producing a bonded product 2 (wherein a copper block was bonded to a copper substrate) by the same method as that in Example 1. Then, the shear strength was obtained by the same method as that in Example 1. As a result, the shear strength was 28 MPa, so that the bond strength was low. The bonding material 4 was used for attempting to bond an SiC chip (the bonded surface of which was not plated with silver) to a copper substrate via the silver bonding layer by the same method as that in Example 1. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 84 nm.

### [Comparative Example 3]

The same bonding material 4 as that in Comparative Example 1 was used for producing a bonded product 1 (wherein an SiC chip having a bonded surface plated with silver was bonded to a copper substrate) by the same method as that in Example 1, except that the load was 15 MPa during burning. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 36 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 57 % which was higher than 30 %, so that the bonding of the silver bonding layer of the bonded product 1 was not good.

The bonding material 4 was used for producing a bonded product 2 (wherein a copper block was bonded to a copper substrate) by the same method as that in Example 1, except that the load was 15 MPa during burning. Then, the shear strength was obtained by the same method as that in Example 1. As a result, the shear strength was 49 MPa, so that the bond strength was low. The bonding material 4 was used for attempting to bond an SiC chip (the bonded surface of which was not plated with silver) to a copper substrate via the silver bonding layer by the same method as that in Example 1, except that the load was 15 MPa during burning. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 75 nm.

### [Comparative Example 4]

The same bonding material 4 as that in Comparative Example 1 was used for producing a bonded product 1 (wherein an SiC chip having a bonded surface plated with silver was bonded to a copper substrate) by the same method as that in Example 1, except that the load was 30 MPa during burning. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 33 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 38 % which was higher than 30 %, so that the bonding of the silver bonding layer of the bonded product 1 was not good.

The bonding material 4 was used for producing a bonded product 2 (wherein a copper block was bonded to a copper substrate) by the same method as that in Example 1, except that the load was 30 MPa during burning. Then, the shear strength was obtained by the same method as that in Example 1. As a result, the shear strength was 133 MPa, so that the bond strength was high. The bonding material 4 was used for attempting to bond an SiC chip (the bonded surface of which was not plated with silver) to a copper substrate via the silver bonding layer by the same method as that in Example 1, except that the load was 30 MPa during burning. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 80 nm.

### [Comparative Example 5]

A bonding material 5 of a silver paste containing 81.54 % by weight of silver particles 2, 12.48 % by weight of the first solvent (ODO), 5.97 % by weight of the second solvent (IPTL-A) and 0.01 % by weight of the sintering aid (DGA) was obtained by the same method as that in Comparative Example 1, expect that the same fine silver particles (having an average primary particle diameter of 60 nm) (silver particles 2) as those in Example 2 were used in place of the same fine silver particles (having an average primary particle diameter of 85 nm) (silver particles 1) as those in Example 1 and that the amount of octanediol (ODO) added as the diluent was 0.56 g.

With respect to this bonding material 5, the viscosity, Ti value, content of Ag and particle size thereof were obtained by the same methods as those in Example 1. As a result, the viscosity measured at 25 °C and 5 rpm was 38 (Pa ▪ s), the Ti value was 4.2, and the content of Ag was 80.0 % by weight. The first scratch was not larger than 15 *µ*m, the fourth scratch was not larger than 11 *µ*m, and the average particle diameter D₅₀ was not larger than 6 *µ*m.

The bonding material 5 was used for producing a bonded product 1 (wherein an SiC chip having a bonded surface plated with silver was bonded to a copper substrate) by the same method as that in Example 1, except that the load was 5 MPa during burning. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 33 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 100 % which was higher than 30 %, so that the bonding of the silver bonding layer of the bonded product 1 was not good.

The bonding material 5 was used for producing a bonded product 2 (wherein a copper block was bonded to a copper substrate) by the same method as that in Example 1, except that the load was 5 MPa during burning. Then, the shear strength was obtained by the same method as that in Example 1. As a result, the shear strength was 31 MPa, so that the bond strength was low. The bonding material 5 was used for attempting to bond an SiC chip (the bonded surface of which was not plated with silver) to a copper substrate via the silver bonding layer by the same method as that in Example 1, except that the load was 5 MPa during burning. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 68 nm.

### [Comparative Example 6]

The same bonding material 5 as that in Comparative Example 1 was used for producing a bonded product 1 (wherein an SiC chip having a bonded surface plated with silver was bonded to a copper substrate) by the same method as that in Example 1, except that the load was 30 MPa during burning. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 34 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 53 % which was higher than 30 %, so that the bonding of the silver bonding layer of the bonded product 1 was not good.

The bonding material 5 was used for producing a bonded product 2 (wherein a copper block was bonded to a copper substrate) by the same method as that in Example 1, except that the load was 30 MPa during burning. Then, the shear strength was obtained by the same method as that in Example 1. As a result, the shear strength was 128 MPa, so that the bond strength was high. The bonding material 5 was used for attempting to bond an SiC chip (the bonded surface of which was not plated with silver) to a copper substrate via the silver bonding layer by the same method as that in Example 1, except that the load was 30 MPa during burning. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 84 nm.

### [Comparative Example 7]

A bonding material 6 of a silver paste containing 40.54 % by weight of silver particles 1, 40.54 % by weight of silver particles 2, 12.98 % by weight of the first solvent (ODO), 5.93 % by weight of the second solvent (IPTL-A) and 0.01 % by weight of the sintering aid (DGA) was obtained by the same method as that in Comparative Example 1, expect that 41.0 g of the same fine silver particles (having an average primary particle diameter of 85 nm) (silver particles 1) as those in Example 1 and 41.0 g of the same fine silver particles (having an average primary particle diameter of 60 nm) (silver particles 2) as those in Example 2 were used in place of 82.0 g of the same fine silver particles (having an average primary particle diameter of 85 nm) (silver particles 1) as those in Example 1 and that the amount of octanediol (ODO) added as the diluent were 1.13 g.

With respect to this bonding material 6, the viscosity, Ti value, content of Ag and particle size thereof were obtained by the same methods as those in Example 1. As a result, the viscosity measured at 25 °C and 5 rpm was 29 (Pa ▪ s), the Ti value was 3.7, and the content of Ag was 80.1 % by weight. The first scratch was not larger than 20 *µ*m, the fourth scratch was not larger than 14 *µ*m, and the average particle diameter D₅₀ was not larger than 6 *µ*m.

The bonding material 6 was used for producing a bonded product 1 (wherein an SiC chip having a bonded surface plated with silver was bonded to a copper substrate) by the same method as that in Example 1. Then, the presence of voids in the silver bonding layer was observed, and the thickness of the silver bonding layer was obtained, by the same methods as those in Example 1. As a result, no voids were observed in the silver bonding layer, and the thickness of the silver bonding layer was 38 *µ*m. With respect to this bonded product 1, the hot-cold shock test was carried out by the same method as that in Example 1. Thereafter, by the same methods as those in Example 1, the presence of voids in the silver bonding layer was observed, and the crack progress ratio of the silver bonding layer was obtained. As a result, voids were observed at four corners on the surface of the silver bonding layer of the bonded product 1. The crack progress ratio was 93 % which was higher than 30 %, so that the bonding of the silver bonding layer of the bonded product 1 was not good.

The bonding material 6 was used for producing a bonded product 2 (wherein a copper block was bonded to a copper substrate) by the same method as that in Example 1. Then, the shear strength was obtained by the same method as that in Example 1. As a result, the shear strength was 32 MPa, so that the bond strength was low. The bonding material 6 was used for attempting to bond an SiC chip (the bonded surface of which was not plated with silver) to a copper substrate via the silver bonding layer by the same method as that in Example 1. As a result, the SiC chip (the bonded surface of which was not plated with silver) was not bonded to the silver bonding layer. With respect to this silver bonding layer, the crystalline diameter (Dx) was obtained by the same method as that in Example 1. As a result, the crystalline diameter on (111) plane was 86 nm.

The results in these examples and comparative examples are shown in Tables 1-3.

**Table 1**

| | Contents in Silver Paste (wt%) | | | | | | |
|---|---|---|---|---|---|---|---|
| | Silver Particles | | | 1st Solvent | 2nd Solvent | Dispersant | Sintering Aid |
| | 1 | 2 | 3 | | | | |
| Ex.1 | 89.0 | - | - | 9.25 | 1.5 | 0.25 | - |
| Ex.2 | - | 45.0 | 45.0 | 9.25 | 0.5 | 0.25 | - |
| Ex.3 | - | 46.5 | 46.5 | 6.25 | 0.5 | 0.25 | - |
| Comp.1 -4 | 81.33 | - | - | 12.71 | 5.95 | - | 0.01 |
| Comp.5 -6 | - | 81.54 | - | 12.48 | 5.97 | - | 0.01 |
| Comp.7 | 40.5 4 | 40.54 | - | 12.98 | 5.93 | - | 0.01 |

**Table 2**

| | Content of Ag (wt%) | Particle Diameter (µm) | | | Viscosity (Pa ▪ s) | Ti |
|---|---|---|---|---|---|---|
| | | 1st | 4th | D₅₀ | | |
| Ex.1 | 88.4 | < 1 | < 1 | < 1 | 36 | 3.1 |
| Ex.2 | 89.2 | < 1 | < 1 | < 1 | 6.5 | 2.5 |
| Ex.3 | 92.1 | < 1 | < 1 | < 1 | 40 | 5.4 |
| Comp.1-4 | 80.2 | < 16 | < 10 | < 4 | 25 | 3.5 |
| Comp.5-6 | 80.0 | < 15 | < 11 | < 6 | 38 | 4.2 |
| Comp.7 | 80.1 | < 20 | < 14 | < 6 | 29 | 3.7 |

**Table 3**

| | Bonded Product 1 | | | Bonded Product 2 | | Bonded Product 3 | |
|---|---|---|---|---|---|---|---|
| | Load (MP a) | Thickness of Silver Bonding Layer (µm) | Crack Progress Ratio (%) | Load (MP a) | Shear Strength (MPa) | Load (MP a) | Crystal-line Diam-eter (nm) |
| Ex.1 | 10 | 46 | 17 | 10 | 113 | 10 | 69 |
| Ex.2 | 10 | 46 | 26 | 10 | 78 | 10 | 71 |
| Ex.3 | 10 | 60 | 17 | 10 | 93 | 10 | 73 |
| Comp.1 | 5 | 41 | 100 | 5 | 38 | 5 | 98 |
| Comp.2 | 10 | 37 | 79 | 10 | 28 | 10 | 84 |
| Comp.3 | 15 | 36 | 57 | 15 | 49 | 15 | 75 |
| Comp.4 | 30 | 33 | 38 | 30 | 133 | 30 | 80 |
| Comp.5 | 5 | 33 | 100 | 5 | 31 | 5 | 68 |
| Comp.6 | 30 | 34 | 53 | 30 | 128 | 30 | 84 |
| Comp.7 | 10 | 38 | 93 | 10 | 32 | 10 | 86 |

As can be seen from Tables 1 through 3, if the silver bonding layer has a shear strength of not less than 60 MPa and a crystalline diameter of not larger than 78 nm on (111) plane thereof as the bonded products in Examples 1 through 3, it is possible to bond an electronic part to a copper substrate by means of a silver bonding layer which is difficult to form large cracks even if the cooling/heating cycle is repeated. Furthermore, it can be found from the comparison of Comparative Examples 1 through 4 with each other that, if the pressure during bonding is higher, the thickness of the silver bonding layer is thinner and the shear strength is higher, but the crystalline diameter of the silver bonding layer on (111) plane is greater than 78 nm and the crack progress ratio is higher than 30 %. It can be also found that, if a sintering aid serving as an addition agent is added to the bonding material as Comparative Examples 1-7, the sintering promotes to increase the shear strength of the silver bonding layer, but the crystalline diameter of the silver bonding layer on (111) plane is greater than 78 nm and the crack progress ratio is higher than 30 %. Moreover, it can be found from the comparison of Comparative Example 1 with Comparative Example 5 that, if the particle diameter of the fine silver particles of the bonding material is decreased, the shear strength of the silver bonding layer is increased, but the crystalline diameter of the silver bonding layer on (111) plane is greater than 78 nm and the crack progress ratio is higher than 30 %.

### Description of Reference Numbers

- 10: Substrate
- 12: Silver Bonding Layer
- 14: Electronic Part

## Claims

1. A bonded product comprising:
a substrate;
a silver bonding layer containing a sintered body of silver; and
an electronic part which is bonded to the substrate via the silver bonding layer,
wherein the silver bonding layer has a shear strength of not less than 60 MPa and a crystalline diameter of not larger than 78 nm on (111) plane thereof.

2. A bonded product as set forth in claim 1, wherein a bonded surface of said electronic part to the silver bonding layer is plated with a noble metal.

3. A bonded product as set forth in claim 1, wherein a bonded surface of said electronic part to the silver bonding layer is plated with silver.

4. A bonded product as set forth in claim 1, wherein said electronic part is an SiC chip.

5. A bonded product as set forth in claim 1, wherein said substrate is a copper substrate.

6. A bonding material of a silver paste containing fine silver particles,
wherein a silver bonding layer has a shear strength of not less than 60 MPa and has a crystalline diameter of not larger than 78 nm on (111) plane thereof when the silver bonding layer is formed by sintering silver in the bonding material by burning the bonding material at 280 °C for 180 seconds after the bonding material is applied on a copper substrate to raise the temperature thereof to 280 °C in 120 seconds while a load of 10 MPa is applied thereon in the atmosphere.

7. A bonding material as set forth in claim 6, wherein said fine silver particles have an average primary particle diameter of 1 to 100 nm.

8. A bonding material as set forth in claim 6, which further contains silver particles having an average primary particle diameter of 0.2 to 10 *µ*m.
